(19) Europäisches Patentamt
European Patent Office
Office européen des brevets

(11) EP 1 786 100 A1

(12) # EUROPEAN PATENT APPLICATION
published in accordance with Art. 158(3) EPC

(43) Date of publication:
**16.05.2007 Bulletin 2007/20**

(21) Application number: **05770513.9**

(22) Date of filing: **09.08.2005**

(51) Int Cl.:
***H03H 9/64*** *(2006.01)* ***H03H 9/145*** *(2006.01)*

(86) International application number:
**PCT/JP2005/014551**

(87) International publication number:
**WO 2006/025193 (09.03.2006 Gazette 2006/10)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **02.09.2004 JP 2004255914**

(71) Applicant: **MURATA MANUFACTURING CO., LTD.**
**Nagaokakyo-shi, Kyoto 617-8555 (JP)**

(72) Inventor: **TANI, Masakazu**
**tari 1-chome, Nagaokakyo-shi, Kyoto 6178 (JP)**

(74) Representative: **Joly, Jean-Jacques et al**
**Cabinet Beau de Loménie**
**158, rue de l'Université**
**75340 Paris Cédex 07 (FR)**

(54) **BALANCE TYPE ELASTIC SURFACE-WAVE FILTER**

(57) To improve amplitude balancing and phase balancing in the passband in a balanced-type surface acoustic wave filter having a balanced-to-unbalanced conversion function in which first and second surface acoustic wave filter portions are two-stage cascade connected.

In a balanced type surface acoustic wave filter 1, a first longitudinal coupling resonator-type surface acoustic wave filter portion 11 connected to an unbalanced input terminal 33 and a second longitudinal coupling resonator-type surface acoustic wave filter portion 21 connected to first and second balanced input terminals 34 and 35 are two-stage cascade connected. In the first longitudinal coupling resonator-type surface acoustic wave filter portion 11, in a portion in which first and second IDTs 12 and 13 neighbor each other and a portion in which second and third IDTs 13 and 14 neighbor each other, weighting is performed on a plurality of electrode fingers 14a and 14b including the outermost electrode finger 14a, the closest to the opposite IDT, in one and/or the other of the neighboring IDTs 13 and 14.

**FIG.1**

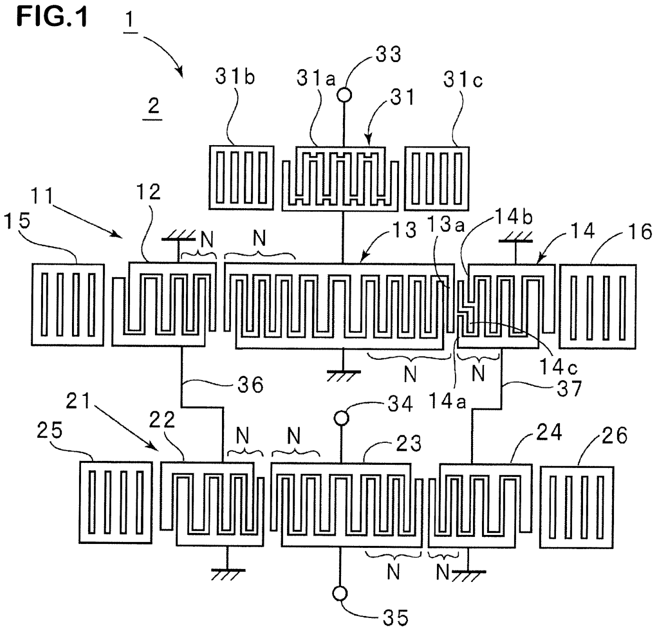




Printed by Jouve, 75001 PARIS (FR)

## Description

### Technical Field

The present invention relates to a balanced-type surface acoustic wave filter having a balanced-to-unbalanced conversion function and more particularly to a balanced-type surface acoustic wave filter in which first and second longitudinal coupling resonator-type surface acoustic wave filter portions are cascade connected.

### Background Art

In recent years, with the reduction in size and weight of communication devices such as portable telephones, etc., surface acoustic wave filters are widely used as a bandpass filter which can be made smaller. Furthermore, with the reduction in size of communication devices, the combination of constituent parts advances. Then, among such surface acoustic wave filters, a surface acoustic wave filter having a balanced-to-unbalanced conversion function has been used.

For example, in Patent Document 1 mentioned below, a longitudinal coupling resonator-type surface acoustic wave filter having a balanced-to-unbalanced conversion function shown in Fig. 9 is disclosed.

As shown in Fig. 9, in a surface acoustic wave filter 300 described in Patent Document 1, an electrode structure shown in Fig. 9 is formed on a surface wave substrate. That is, a first longitudinal coupling resonator-type surface acoustic wave filter portion 301 and a second longitudinal coupling resonator-type surface acoustic wave filter portion 302 are constituted. In the surface acoustic wave filter portion 301, first to third IDTs 303 to 305 are disposed in the surface wave propagation direction. Reflectors 306 and 307 are disposed on both sides in the surface wave propagation direction of an area in which the IDTs 303 to 305 are disposed.

In the same way, also in the second surface acoustic wave filter portion 302, fourth to sixth IDTs 308 to 310 are disposed along the surface wave propagation direction. Reflectors 311 and 312 are disposed on both sides in the surface wave propagation direction of the IDTs 308 to 310.

One terminal of the first surface acoustic wave filter portion 301 is connected to an unbalanced input terminal 313. The first and second surface acoustic wave filter portions 301 and 302 are cascade connected. Then, one terminal of the IDT 309 of the second surface acoustic wave filter portion 302 is connected to a first balanced output terminal 314 and the other terminal is connected to a second balanced output terminal 315.

Here, the first and second surface acoustic wave filter portions 301 and 302 are cascade connected. Furthermore, a signal flowing in a signal line 316 for connecting the IDT 303 and the IDT 308 is opposite in phase to a signal flowing in a signal line 317 for connecting between the IDTs 305 and 310.

On the other hand, in Patent Document 2 mentioned below, a surface acoustic wave filter with a balanced-to-unbalanced conversion function having an electrode structure shown in Fig. 10 is disclosed. As shown in Fig. 10, a longitudinal coupling resonator-type surface acoustic wave filter 400 is constructed in the same way as the surface acoustic wave filter 300 shown in Fig. 9 except in that weighting is performed in a second surface acoustic wave filter portion 402 and that narrow-pitched electrode-finger portions are contained in the first and second surface acoustic wave filter portions 401 and 402. Accordingly, corresponding reference numerals are given to corresponding portions and their description is omitted.

Here, in IDTs 403 to 405 and IDTs 408 to 410, in a pair of neighboring IDTs, a narrow-pitched electrode-finger portion N is formed so that the pitch of a plurality of electrode fingers including the outermost electrode finger on the side of the opposite IDT may be narrower than the pitch of the main electrode fingers of the IDT concerned. The discontinuity in the neighboring portions of the IDTs is eased by forming the narrow-pitched electrode-finger portion N and filter characteristics are improved. In addition, in the longitudinal coupling resonator-type surface acoustic wave filter 400, in the two-stage cascade connection-type structure, in the surface acoustic wave filter portion 402 connected to first and second balanced output terminals 414 and 415, in addition to the above-described narrow-pitched electrode-finger portion, weighting by making electrode-finger cross-widths different is performed.

The balancing is improved in such a way that a signal flowing in one signal line 416 for connecting the first surface acoustic wave filter portion 401 and the second surface acoustic wave filter portion 402 is made different in phase from a signal flowing in the other signal line 417.

Furthermore, when the above-described cross-width weighting is performed, the balancing is further improved.

When the above-described surface acoustic wave device having a balanced-to-unbalanced conversion function is considered to be a three-port device and, for example, the unbalanced input terminal is port 1 and the balanced output terminals are considered to be port 2 and port 3, respectively, the amplitude balancing and phase balancing are defined as follows:

$$\text{Amplitude balancing} = |A| \cdots \text{formula (1)}$$

$$A = |20 \log (S21)| - |20 \log (S31)|$$

$$\text{Phase balancing} = |B| \cdots (2)$$

$$B = |\angle S21 - \angle S31|$$

Moreover, S21 represents a transfer coefficient from port 1 to port 2 and S31 represents a transfer coefficient from port 1 to port 3. Such balancing is ideally considered as follows. That is, in the filter characteristics of a surface acoustic wave device, the amplitude balancing is 0 dB and the phase balancing is 180 degrees in the passband.

Patent Document 1: Japanese Unexamined Patent Application Publication No. 2002-84164
Patent Document 2: Japanese Unexamined Patent Application Publication No. 2004-7713

Disclosure of Invention

As described above, in Patent Documents 1 and 2, the balanced-type surface acoustic wave filters 300 and 400 of a two-element cascade-connection type in which balancing can be improved are disclosed. However, in these surface acoustic wave filters 300 and 400, there is a problem in that a steep spike-like ripple is generated in the amplitude balancing characteristics and phase balancing characteristics in the passband. Accordingly, the improvement of balancing is not sufficient.

It is an object of the present invention to provide a balanced-type surface acoustic wave filter in which the above-described problem in the related technology is solved; in a balanced-type surface acoustic wave filter having first and second longitudinal coupling resonator-type surface acoustic wave filter portions two-stage cascade connected, the generation of the above-described spike-like ripple can be effectively prevented in the amplitude balancing characteristics and phase balancing characteristics in the passband; and accordingly, the balancing is further improved.

A balanced-type surface acoustic wave filter with a balanced-to-unbalanced conversion function having an unbalanced signal terminal and first and second balanced signal terminals of the present invention comprises a piezoelectric substrate; a first longitudinal coupling resonator-type surface acoustic wave filter portion having first to third IDTs disposed along the propagation direction of a surface wave on the piezoelectric substrate, the middle (second) IDT connected to the unbalanced signal terminal; and a second longitudinal coupling resonator-type surface acoustic wave filter portion having fourth to sixth IDTs disposed along the propagation direction of a surface wave on the piezoelectric substrate, the fourth IDT connected to the first IDT, and the fifth IDT connected to the first and second balanced signal terminals. In the balanced-type surface acoustic wave filter, an electric signal passing through a signal line connecting the first IDT and the fourth IDT is about 180 degrees in phase different from an electric signal passing through a signal line connecting the third IDT and the sixth IDT, and, in the first longitudinal coupling resonator-type surface acoustic wave filter portion, in the portion where the first and second IDTs neighbor each other and/or the portion where the second and third IDTs neighbor each other, in one of the neighboring IDTs and/or the other of the neighboring IDTs, weighting is performed on a plurality of electrode fingers including the outermost electrode finger which is the closest to the opposite IDT.

In the present invention, weighting indicates cross-width weighting, series weighting, thinning-out weighting, and duty weighting.

In a specific aspect of a balanced-type surface acoustic wave filter according to the present invention, out of the portion where the first and second IDTs neighbor each other and/or the portion where the second and third IDTs neighbor each other, in the portion where the neighboring outermost electrode fingers are of the same polarity, the weighting is performed.

In another specific aspect of a balanced-type surface acoustic wave filter according to the present invention, the weighting is performed in such a way that the length of a plurality of electrode fingers including the outermost electrode finger is made different from the other electrode fingers.

In another specific aspect of a balanced-type surface acoustic wave filter according to the present invention, the weighting is a cross-width weighting or a series weighting.

In another specific aspect of a balanced-type surface acoustic wave filter according to the present invention, the electrode fingers in which the weighting is performed are disposed in a narrow-pitched electrode-finger portion.

In another specific aspect of a balanced-type surface acoustic wave filter according to the present invention, in the second longitudinal coupling resonator-type surface acoustic wave filter portion, the number of electrode fingers of the fifth IDT positioned in the middle in the propagation direction of a surface wave is an even number.

In another specific aspect of a balanced-type surface acoustic wave filter according to the present invention, one terminal of the fifth IDT in the middle of the second longitudinal resonator-type surface acoustic wave filter portion is connected to a first balanced terminal, and the other terminal is connected to a second balanced signal terminal.

In a balanced-type surface acoustic wave filter according to the present invention, in a structure having first and second longitudinal resonator-type surface acoustic wave filter portions two-stage cascade connected with a balanced-to-unbalanced conversion function, an electric signal being transmitted through a signal line for connecting a first IDT and a fourth IDT is made about 180 degrees in phase different from an electric signal being transmitted through a signal line for connecting a third IDT and a sixth IDT to improve the balancing. In addition, in the first longitudinal coupling resonator-type surface acoustic wave filter portion, that is, in the longitudinal coupling resonator-type surface acoustic wave filter portion connected to an unbalanced terminal, in a portion where first and second IDTs neighbor each other and/or a portion where second and third IDTs neighbor each other, in one and/or the other of the neighboring IDTs, weighting is performed on a plurality of electrode fingers including the outermost electrode finger which is the closest to the opposite IDT, and thus, the spike-like ripple can be effectively suppressed in the amplitude balancing characteristics and phase balancing characteristics in the passband. In particular, in the portion where first and second IDTs neighbor each other and/or the portion where second and third IDTs neighbor each other, when the weighting is performed in a portion where the neighboring outermost electrode fingers are of the same polarity, the spike-like ripple can be more effectively suppressed.

In the present invention, it is where an electric signal flowing in a first balanced signal terminal is 180 degrees in phase different from an electric signal flowing in a second balanced signal terminal, that is, a first coupling resonator-type surface acoustic wave filter portion connected to an unbalanced signal terminal that the above-described spike-like ripple can be effectively suppressed. Accordingly, it is considered that a phenomenon related to the above-described spike-like ripple take place in the portion where the polarity is reversed. Then, in the present invention, when weighting is performed in the portion where the polarity is reversed, it is considered that the spike-like ripple is reduced.

Therefore, according to the present invention, in comparison with a related balanced-type surface acoustic wave filter of this kind, balancing can be much more improved.

On the other hand, in the present invention, although various weighting methods can be used as the above-described weighting, preferably, weighting in which the length of a plurality of electrode fingers including the outermost electrode finger is made different from that of the other electrode fingers can be used. As such a weighting, cross-width weighting and series weighting can be given. When cross-width weighting or series weighting is used, as is made clear from an experimental example to be described later, balancing can be effectively improved.

Electrode fingers in which weighting is performed may be disposed in a narrow-pitched electrode-finger portion and then, the discontinuity between neighboring IDTs can be eased.

In a second longitudinal coupling resonator-type surface acoustic wave filter portion, when the number of electrode fingers of a fifth IDT disposed in the middle in the propagation direction of a surface wave is an even number, it becomes possible to improve balancing in comparison with the case in which the number of electrode fingers of the fifth IDT is an odd number.

Moreover, one terminal of a middle (fifth) IDT of a second longitudinal coupling resonator-type surface acoustic wave filter portion is electrically connected to a first balanced signal terminal, and the other terminal may be electrically connected to a second balanced signal terminal. In this case, without making the structure of the fifth IDT complicated, the second longitudinal coupling resonator-type surface acoustic wave filter portion can be connected to the first and second balanced signal terminals. In addition, it becomes possible to provide a balanced-type surface acoustic wave filter in which the ratio between the impedance on the side of the unbalanced terminal and the impedance on the side of the first and second terminals is made 1 : 1.

Brief Description of the Drawings

Fig. 1 is a schematic top view showing an electrode structure of a balanced-type surface acoustic wave filter according to a first embodiment of the present invention.
Fig. 2 shows characteristics of attenuation to frequency of the surface acoustic wave filter of the first embodiment.
Fig. 3 shows amplitude balancing of the surface acoustic wave filter of the first embodiment.
Fig. 4 shows phase balancing of the surface acoustic wave filter of the first embodiment.
Fig. 5 shows characteristics of attenuation to frequency of a surface acoustic wave filter of a comparative example.

Fig. 6 shows amplitude balancing of the surface acoustic wave filter of the comparative example.

Fig. 7 shows phase balancing of the surface acoustic wave filter of the comparative example.

Fig. 8 is a schematic top view showing an electrode structure of a balanced-type surface acoustic wave filter according to a second embodiment of the present invention.

Fig. 9 is a schematic top view showing one example of a related balanced-type surface acoustic wave filter.

Fig. 10 is a schematic top view showing another example of a related balanced-type surface acoustic wave filter.

Reference Numerals

| | |
|---|---|
| 1 | balanced-type surface acoustic wave filter |
| 2 | piezoelectric substrate |
| 11 | first longitudinal coupling resonator-type surface acoustic wave filter portion |
| 12 to 14 | first to third IDTs |
| 13a, | 14a, and 14b electrode fingers |
| 14c | floating electrode finger |
| 14A | third IDT |
| 15 and 16 | reflectors |
| 21 | second longitudinal coupling resonator-type surface acoustic wave filter portion |
| 22 to 24 | fourth to sixth IDTs |
| 25 and 26 | reflectors |
| 31 | surface acoustic wave resonator |
| 31a | IDT |
| 31b and 31c | reflectors |
| 33 | unbalanced input terminal |
| 34 and 35 | first and second balanced output terminals |
| 36 and 37 | first and second signal lines |
| 41 | balanced-type surface acoustic wave filter |
| 101 | balanced-type surface acoustic wave filter |
| N | narrow-pitched electrode-finger portion |

Best Mode for Carrying Out the Invention

Hereinafter, the present invention is made clear by describing concrete embodiments of the present invention with reference to the drawings.

Fig. 1 is a top view showing an electrode structure of a surface acoustic wave filter according to a first embodiment of the present invention. A balanced-type surface acoustic wave filter 1 of the present embodiment is constituted by forming the illustrated electrode structure on a surface wave substrate 2. Moreover, in the electrode structure shown in Fig. 1, the number of electrode fingers, etc., are made smaller than actual ones to make the illustration easier.

In the surface acoustic wave filter 1, a first longitudinal coupling resonator-type surface acoustic wave filter portion 11 and a second longitudinal coupling resonator-type surface acoustic wave filter portion 21 are cascade connected.

The first longitudinal coupling resonator-type surface acoustic wave filter portion 11 contains first to third IDTs 12 to 14 disposed along the propagation direction of a surface wave. Reflectors 15 and 16 are disposed on both sides in the surface wave propagation direction of an area where the IDTs 12 to 14 are contained. Narrow-pitched electrode-finger portions N are formed in a portion where the IDTs 12 and 13 neighbor each other and a portion where the IDTs 13 and 14 neighbor each other. The narrow-pitched electrode-finger portion N is a portion where the pitch of a plurality of electrode fingers including the outermost electrode finger neighboring the other IDT is narrower than the pitch of the main electrode-finger portion of the IDT concerned.

When the narrow-pitched electrode-finger portions N are contained, the discontinuity between a pair of neighboring IDTs is lessened and filtering characteristics can be improved. But the narrow-pitched electrode-finger portions N are not necessarily required in the present invention.

Furthermore, the second longitudinal coupling resonator-type surface acoustic wave filter portion 21 also contains fourth to sixth IDTs 22 to 24 disposed along the propagation direction of a surface wave and reflectors 25 and 26 disposed in the surface wave propagation direction in an area where the IDTs 22 to 24 are contained in the same way as the first longitudinal coupling resonator-type surface acoustic wave filter portion 11. In the longitudinal coupling resonator-type surface acoustic wave filter portion 21 also, narrow-pitched electrode-finger portions N are formed in a portion where the IDTs 22 to 24 neighbor each other, respectively.

One terminal of the second IDT 13 is connected to an unbalanced input terminal 33 through a one port-type surface acoustic wave resonator 31.

The one port-type surface acoustic wave resonator 31 contains an IDT 31a and reflectors 31b and 31c disposed on both sides in the surface wave propagation direction of the IDT 31a. The one port-type surface acoustic wave resonator 31 is used as an attenuation trap outside the passband of the balanced-type surface acoustic wave filter 1, but the resonator 31 is not essential in the present invention and may be omitted.

Furthermore, in the second longitudinal coupling resonator-type surface acoustic wave filter portion 21, one terminal of the middle (fifth) IDT 23 is connected to a first balanced output terminal 34 and the other terminal is connected to a second balanced output terminal 35. Then, the first IDT 12 and the fourth IDT 22 are connected by a first signal line 36. The third IDT 14 and the sixth IDT 24 are connected by a second signal line 37. Accordingly, the balanced-type surface acoustic wave filter 1 of a two-stage cascade-connection type being connected to the unbalanced input 33 and the first and second balanced output terminals 34 and 35 is constituted.

Now, the IDT 14 is inverted relative to the IDT 12 so that a signal flowing in the first signal line 36 may be 180 degrees in phase different from a signal flowing in the second signal line 37. Accordingly, in the present embodiment, since the phase of the signals flowing in the first and second lines 36 and 37 is 180 degrees in phase inverted from each other to have a balanced-to-unbalanced conversion function, the degree of balancing is excellent.

Also, the present embodiment is characterized in that, since the third IDT 14 is weighted in a portion where the second IDT and the third IDT neighbor each other, the spike-like ripple appearing in the amplitude balancing and phase balancing in the passband can be effectively suppressed.

The outermost electrode finger 13a, on the side of the IDT 14, of the IDT 13 and the outermost electrode finger 14a, on the side of the IDT 13, of the IDT 14 are hot-side electrode fingers and of the same polarity. Then, in the IDT 14, a plurality of electrode fingers 14a and 14b, including the outermost electrode finger 14a on the side of the IDT 13, is series weighted. Series weighting means that weighting is performed by containing a floating electrode finger 14c between the electrode finger 14a and the next electrode finger 14b. The floating electrode finger 14c has a structure in which a first electrode-finger portion extending in the same direction as the electrode finger 14a on the tip side of the electrode finger 14a with a gap from the electrode finger 14a and a second electrode-finger portion extending in the same direction as the electrode finger 14b with a gap on the tip side of the electrode finger 14b are connected by a third electrode-finger portion extending in the surface wave propagation direction. A series weighting is performed in such a away that such a crank-shaped floating electrode finger 14c is contained and that the length of the outermost electrode finger 14a and the length of the electrode finger 14b inside the outermost electrode finger 14a are shortened. In the portion in which such a series weighting is performed, the application of an electric field is changed by the series weighting and, because of that, the spike-like ripple can be effectively suppressed in the amplitude balancing characteristics and phase balancing characteristics in the passband as is made clear from the experimental examples to be described later.

This is described on the basis of concrete experimental examples.

In the present embodiment, a reception bandpass filter for a JCDMA system having a passband of 832 to 870 MHz is constituted. Here, the ratio of the impedance of the unbalanced input terminal 33 to the impedance of the first and second balanced output terminals 34 and 35 is made 1 : 1 2.

A 40 ± 5-degree Y cut X propagation LiTaO3 substrate is prepared as a piezoelectric substrate 2, a film of aluminum is formed, and patterning has been performed to form an electrode structure of a surface acoustic wave filter of the present embodiment. The detail of the electrode structure is described as follows.

In the first and second longitudinal coupling resonator-type surface acoustic wave filter portions 11 and 21, a wavelength decided by the electrode-finger ratio outside the narrow-pitched electrode-finger portion is made λI.

Electrode-finger cross width: 46.5 λI

The number of electrode fingers of the first to third IDTs 12 to 14 is made 23(7) / (7) 36 (7) / (7) 23 in the order of the first to third IDTs 12 to 14. Moreover, the number in the parentheses represents the number of electrode fingers in the narrow-pitched electrode-finger portions, and the number of electrode fingers outside the parentheses represents the number of electrode fingers outside the narrow-pitched electrode-finger portions of the IDTs. Accordingly, when the first IDT is taken as an example, the number of electrode fingers in the narrow-pitched electrode-finger portion is 7 and the number of electrode fingers outside the narrow-pitched electrode-finger portions is 23.

The number of electrode fingers in the fourth to sixth IDTs 22 to 24 is 24(6) / (4)18(4) / (6)24.

The wavelength λI of an electrode-finger portion outside the narrow-pitched electrode-finger portion of the second IDT 13 is equal to 4.73 μm, and the wavelength of the narrow-pitched electrode-finger portion of the second IDT 13 is equal to 4.30 μm. The wavelength λI of electrode-finger portions outside the narrow-pitched electrode-finger portions of the first and third IDTs 12 and 14 is equal to 4.64 μm, and the wavelength λ2n of the narrow-pitched electrode-finger portion of the IDTs 12 and 14 is equal to 4.37 μm.

The electrode-finger pitch λI outside the narrow-pitched electrode-finger portion of the fifth IDT 23 is equal to 4.73 μm, the electrode-finger pitch λn of the narrow-pitched electrode-finger portion of the fifth IDT 23 is equal to 4.25 μm, the electrode-finger pitch λ2I outside the narrow-pitched electrode-finger portion of the fourth and sixth IDTs 22 and 24 is equal to 4.64 μm, and the electrode-finger pitch of the narrow-pitched electrode-finger portion of the fourth and sixth IDTs 22 and 24 is equal to 4.31 μm.

The number of electrode fingers of the reflectors 15, 16, 25, and 26 is made 70, respectively. Furthermore, although the metallization ratio is made 0.65, the metallization of the narrow-pitched electrode-finger portion in the first longitudinal coupling resonator-type surface acoustic wave filter portion 11 is 0.70, and the metallization ratio of the narrow-pitched electrode-finger portion in the second longitudinal coupling resonator-type surface acoustic wave filter portion 21 is made 0.65. Furthermore, The electrode film thickness is made 0.09 λI.

Furthermore, when the wavelength decided by an electrode-finger pitch is represented by λI, the surface acoustic wave resonator 31 is constituted as follows.

Cross width: 15.4 λI
Number of electrode fingers of IDT 31a: 141
Number of electrode fingers of reflectors 31b and 31c: 18 each
Metallization ratio: 0.75
Electrode film thickness: 0.09 λI

Moreover, in the present embodiment, when wiring is actually formed on the piezoelectric substrate, a terminal portion, on the side to be connected to the ground potential, of the first IDT 12 in Fig. 1 and a terminal, on the side to be connected to the ground potential, of the fourth IDT 22 are connected by a connection wiring and, in the same way, the terminal portions, on the side to be connected to the ground potential, of the IDTs 14 and 24 may be connected to each other by a connection wiring.

The attenuation to frequency characteristics of the surface acoustic wave filter 1 of the present embodiment constructed as described above are shown in Fig. 2, and the amplitude balancing characteristics and phase balancing characteristics are shown in Figs. 3 and 4, respectively.

For comparison, a surface acoustic wave filter constructed in the same way except in that the narrow-pitched electrode-finger portion, on the side of the IDT 13, of the IDT 14 is not series weighted was produced and the electrical characteristics were measured. Fig. 5 shows the attenuation to frequency characteristics of a surface acoustic wave filter as a comparative example prepared for comparison. Fig. 6 shows the amplitude balancing characteristics, and Fig. 7 shows the phase balancing characteristics.

When Fig. 2 and Fig. 5 are compared, both have the passband of 832 to 870 MHz. However, when the amplitude balancing and phase balancing in the passband are compared, in the comparative example, the amplitude balancing is 0.83 dB and the phase balancing is 3.6 degrees as a deviation from 180 degrees, and, in the present embodiment, the amplitude balancing is 0.17 dB and the phase balancing is 1.7 degrees as a deviation from 180 degrees. Therefore, according to the present embodiment, it is understood that the amplitude balancing is improved about 0.65 dB and the phase balancing is improved about 2 degrees.

It is understood that this is caused by the following.

That is, in a plurality of electrode fingers 14a and 14b including the outermost electrode finger 14a, on the side of the IDT 13, of the IDT 14, series weighting is performed so as to contain the above-described floating electrode finger 14c. On the other hand, the portions in which the IDT 13 and the IDT 14 neighbor each other are of the same polarity. That is, both electrode fingers 13a and 14a are electrode fingers on the hot side. Then, a signal in the portion where the IDTs 13 and 14 neighbor each other is 180 degrees reversed in phase to that in the portion where the IDTs 12 and 13 neighbor each other. On the other hand, it is considered that the spike-like ripple in the amplitude balancing characteristics and phase balancing characteristics which were described above are caused by the portion in which the phase is reversed. In the present embodiment, in this portion, when the above-described series weighting is performed, the application of an electric field to the portion in which the polarity is reversed changes, and, because of that, it is considered that the spike-like ripple appearing on the amplitude balancing and phase balancing in the passband can be effectively suppressed.

That is, in the structure in which the first and second longitudinal coupling resonator-type surface acoustic wave filter portions 11 and 12 are two-stage cascade connected, on the side of the first surface acoustic wave filter 11 connected to the unbalanced input terminal 33, since a signal in the portion in which the first and second IDTs 12 and 13 neighbor each other is reversed in phase to that in the portion in which the second and third IDTs 13 and 14 neighbor each other as described above, in the portion in which the outermost electrode fingers neighboring each other are of the same polarity, when weighting is performed so that the application of an electric field to at least one IDT is changed as described above, in the same way, the above-described spike-like ripple can be effectively suppressed.

Accordingly, in the present embodiment, although series weighting is performed on the side of the IDT 14, series weighting may be performed on the side of the IDT 13, and also series weighting may be performed on the both sides in the portion in which the IDTs 13 and 14 neighbor each other.

Furthermore, in the present embodiment, in the IDT 14, not only the above-described series weighting is performed, but also the narrow-pitched electrode-finger portion N is contained. That is, although it is enough that only the weighting is performed in order to improve the above-described balancing, the narrow-pitched electrode-finger portion N may be simultaneously used. Practically, in the IDT 14, the series weighting and the narrow-pitched electrode-finger portion N are used at the same time.

In the first longitudinal coupling resonator-type surface acoustic wave filter portion 11, the number of electrode fingers of the middle (second) IDT 13 is an odd number. Accordingly, the third IDT 14 is inverted to the first IDT 12, and a signal flowing in the first signal line 36 is reversed in phase to a signal flowing in the second signal line 37. In the case of such a structure, as described above, in the portion in which the IDTs 13 and 14 neighbor each other, the outermost electrode fingers which are close to each other are electrode fingers on the hot side.

In contrast to this, the number of electrode fingers of the IDT 13 may be made an even number. In this case, the first IDT and the third IDT are not inverted. Then, in this case, although the outermost electrode fingers where the second and third IDTs are close to each other are ground terminals, when the electrode fingers close to each other in this way are of the same polarity, a combination of not only hot to hot, but also ground to ground may be acceptable.

That is, in the first longitudinal coupling resonator-type surface acoustic wave filter portion connected to the unbalanced terminal, in the portion in which the first and second IDTs and the second and third IDTs neighbor each other, the portions where the outermost electrode fingers of the IDTs neighboring each other are of the same polarity may be made a combination of a grounded electrode finger and a grounded electrode finger.

Furthermore, in the longitudinal coupling resonator-type surface acoustic wave filter 1 of the present embodiment, the number of electrode fingers of the middle (fifth) IDT 23 connected to first and second balanced output terminals 34 and 35 is made an even number. In comparison with the case in which the total number of electrode fingers of the middle (fifth) IDT 23 of the surface acoustic wave filter portion 21 connected to the balanced output terminals 34 and 35 is an odd number, when the number is an even number, the balancing can be more effectively improved and that is desirable.

That is, by seeking the difference between the output of the first IDT 12, the fourth IDT 22, the fifth IDT 23, and the first balanced output terminal 34 and the output of the third IDT 14, the sixth IDT 24, the fifth IDT 23, and the second balanced signal terminal 35 by using a balanced-type IC connected to the fifth IDT, the output of the surface acoustic wave filter 1 becomes about double. Furthermore, since the output directly reaching the first balanced output terminal and the output directly reaching the second balanced signal terminal 35 are of the same phase, the outputs cancel each other by seeking the difference between them and the remainder is output as noise of the same phase signal. In such a structure, it becomes a problem that the output directly reaching the first balanced output terminal 34 is large in comparison with the output directly reaching the second balanced output terminal 35. However, in the present embodiment, since the wave directly reaching the first balanced signal terminal 34 through the signal line 36 to the fourth IDT 22 from the first IDT 12 and the wave directly reaching the first balanced signal terminal 34 through the signal line 37 cancel each other, the balancing can be also improved by that.

Moreover, in the case in which the number of electrode fingers of the middle (fifth) IDT 23 of the second longitudinal coupling resonator-type surface acoustic wave filter portion 21 is an odd number, it is hard to generate the spike-like ripple in the amplitude balancing characteristics and phase balancing characteristics, but it is feared that the balancing characteristics may be worsened. It is understood that this is caused by the difference between the number of electrode fingers connected to the first balanced output terminal 34 and the number of electrode fingers connected to the second balanced output terminal 35. Accordingly, preferably, as described above, the number of electrode fingers of the middle (fifth) IDT 23 in the second surface acoustic wave filter portion 21 is made an even number.

In the first embodiment of the present invention in Fig. 1, although the one-port surface acoustic wave resonator 31 is inserted between the unbalanced input terminal 33 and one terminal of the second IDT 13, a first one-port surface acoustic wave resonator may be inserted between the first balanced output terminal 34 and the fifth IDT 23, and a second one-port surface acoustic wave resonator may be inserted between the second balanced output terminal 35 and the fifth IDT 23.

Furthermore, two one-port surface acoustic wave resonators may be contained between the first longitudinal coupling surface acoustic wave filter portion 11 and the second longitudinal coupling surface acoustic wave filter portion 21, a first one-port surface acoustic wave resonator may be inserted between the first IDT 12 and the fifth fourth IDT 22, and a second one-port surface acoustic wave resonator may be inserted between the third IDT 14 and the IDT 24.

Furthermore, a two-port surface acoustic wave resonator may be contained between the first longitudinal coupling surface acoustic wave filter portion 11 and the second longitudinal coupling surface acoustic wave filter portion 21, a first port of the two-port surface acoustic wave resonator may be inserted between the first IDT 12 and the fourth IDT 22, and a second port of the two-port surface acoustic wave resonator may be inserted between the third IDT 14 and the sixth IDT 24.

Fig. 8 is a schematic top view showing an electrode structure of a longitudinal coupling resonator-type surface acoustic wave filter according to a second embodiment of the present invention. In a surface acoustic wave filter 101 of the second embodiment, the structure is the same as that of the longitudinal coupling resonator-type surface acoustic wave filter 1 of the first embodiment except in that, in a third IDT 14A, not series weighting, but cross-width weighting is performed. Accordingly, the same portion is given the same reference numeral and the description is omitted.

In the present embodiment, in the first longitudinal coupling resonator-type surface acoustic wave filter portion 11 connected to the unbalanced input terminal 33, the outermost electrode finger 13a, on the side of the IDT 14A, of the IDT 13 and the outermost electrode finger 14a, on the side of the IDT 13, of the IDT 14A are electrodes on the hot side and of the same polarity. Then, in the IDT 14A, cross-width weighting is performed in a plurality of electrode fingers 14a to 14c including the outermost electrode finger 14a.

Also in the case in which cross-width weighting instead of series weighting is used in this way, the way of application of an electric field is changed in a portion where the IDT 14A and the IDT 13 neighbor each other and accordingly, the spike-like ripple in the amplitude balancing characteristics and phase balancing characteristics can be effectively suppressed.

As is clear from the first and second embodiments, in the present invention, the weighting for improvement of the above-described amplitude balancing and phase balancing is not limited to series weighting and may include cross-width weighting, or weighting by thinning-out and weighting by changing duty ratio may be further used. However, since the way of application of an electric field in the phase inversion portion of a signal can be effectively changed, weighting in which the length of a plurality of electrode fingers including the outermost electrode finger is changed, like series weighting and cross-width weighting, is desirable.

## Claims

1. A balanced-type surface acoustic wave filter with a balanced-to-unbalanced conversion function having an unbalanced signal terminal and first and second balanced signal terminals comprising:

    a piezoelectric substrate;
    a first longitudinal coupling resonator-type surface acoustic wave filter portion having first to third IDTs disposed along the propagation direction of a surface wave on the piezoelectric substrate, the middle second IDT connected to the unbalanced signal terminal; and
    a second longitudinal coupling resonator-type surface acoustic wave filter portion having fourth to sixth IDTs disposed along the propagation direction of a surface wave on the piezoelectric substrate, the fourth IDT connected to the first IDT, and the fifth IDT connected to the first and second balanced signal terminals,

    wherein an electric signal passing through a signal line connecting the first IDT and the fourth IDT is about 180 degrees in phase different from an electric signal passing through a signal line connecting the third IDT and the sixth IDT, and
    wherein, in the first longitudinal coupling resonator-type surface acoustic wave filter portion, in the portion where the first and second IDTs neighbor each other and/or the portion where the second and third IDTs neighbor each other, in one of the neighboring IDTs and/or the other of the neighboring IDTs, weighting is performed on a plurality of electrode fingers including the outermost electrode finger which is the closest to the opposite IDT.

2. A balanced-type surface acoustic wave filter as claimed in claim 1, wherein, out of the portion where the first and second IDTs neighbor each other and/or the portion where the second and third IDTs neighbor each other, in the portion where the neighboring outermost electrode fingers are of the same polarity, the weighting is performed.

3. A balanced-type surface acoustic wave filter as claimed in claim 1 or 2, wherein the weighting is performed in such a way that the length of a plurality of electrode fingers including the outermost electrode finger is made different from the other electrode fingers.

4. A balanced-type surface acoustic wave filter as claimed in claim 3, wherein the weighting is a cross-width weighting or a series weighting.

5. A balanced-type surface acoustic wave filter as claimed in any one of claims 1 to 4, wherein the electrode fingers in which the weighting is performed are disposed in a narrow-pitched electrode-finger portion.

6. A balanced-type surface acoustic wave filter as claimed in any one of claims 1 to 5, wherein, in the second longitudinal coupling resonator-type surface acoustic wave filter portion, the number of electrode fingers of the fifth IDT positioned in the middle in the propagation direction of a surface wave is an even number.

7. A balanced-type surface acoustic wave filter as claimed in any one of claims 1 to 6, wherein one terminal of the fifth IDT in the middle of the second longitudinal resonator-type surface acoustic wave filter portion is connected to a first balanced terminal, and the other terminal is connected to a second balanced signal terminal.

FIG.1

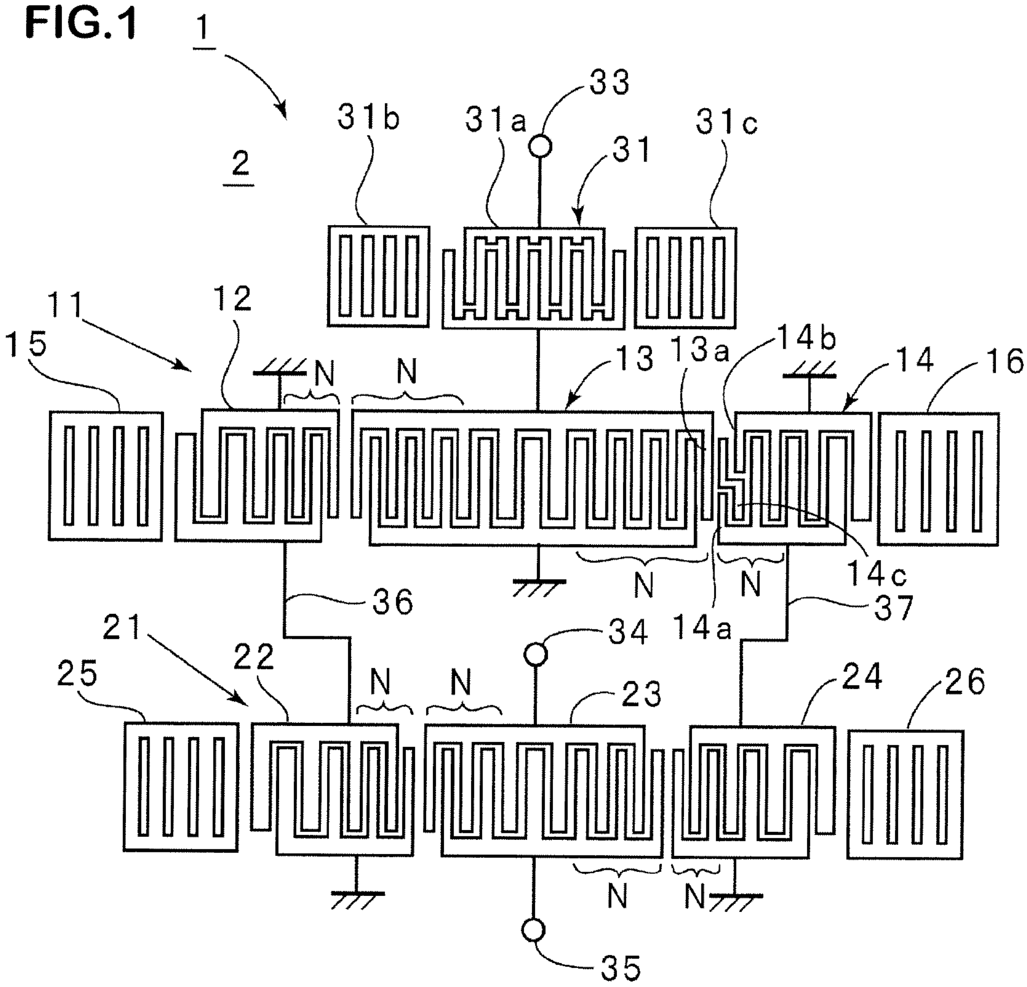
1
2
31b
31a
33
31
31c
11
12
15
13
13a
14b
14
16
N
N
N
N
14c
36
37
14a
34
21
22
25
N
N
23
24
26
N
N
35

FIG.2

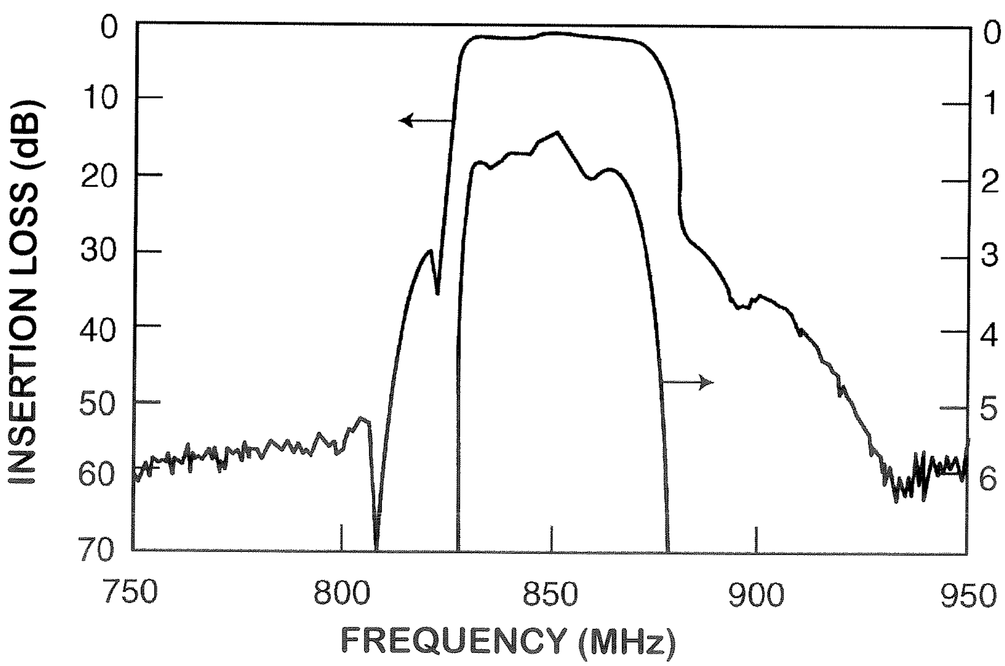
INSERTION LOSS (dB)
0
10
20
30
40
50
60
70
0
1
2
3
4
5
6
750
800
850
900
950
FREQUENCY (MHz)

FIG.3

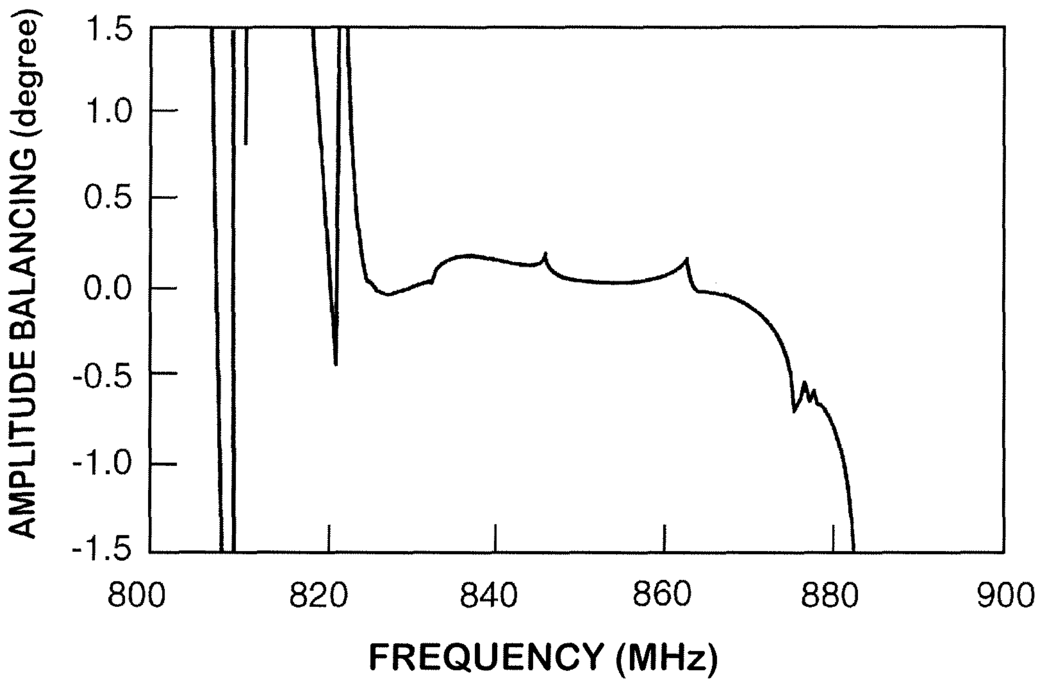
AMPLITUDE BALANCING (degree)
1.5
1.0
0.5
0.0
-0.5
-1.0
-1.5
800
820
840
860
880
900
FREQUENCY (MHz)

FIG.4

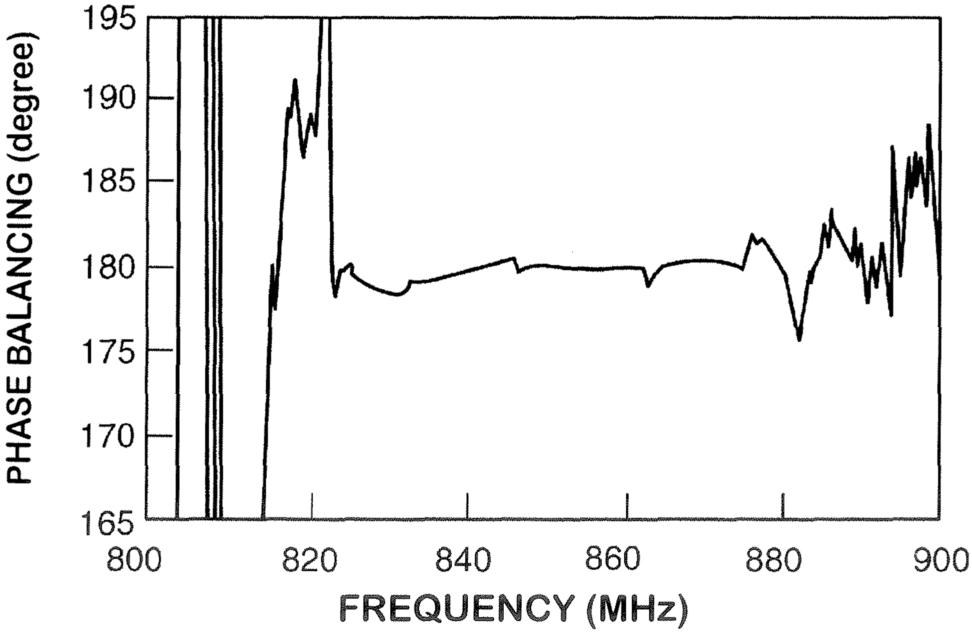
PHASE BALANCING (degree)
195
190
185
180
175
170
165
800
820
840
860
880
900
FREQUENCY (MHz)

FIG.5

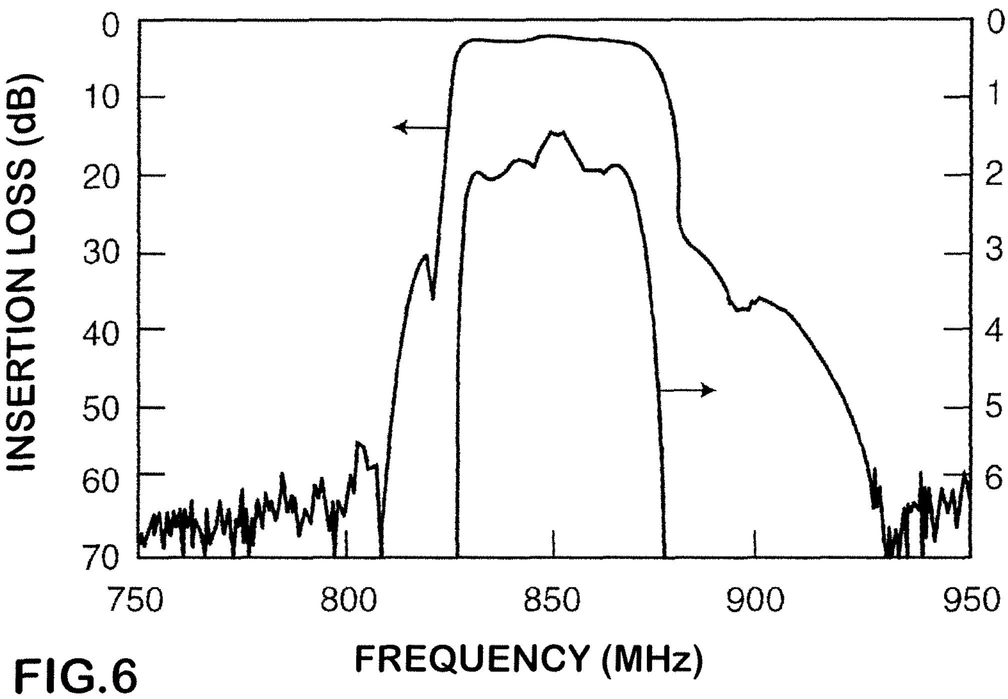
INSERTION LOSS (dB)
0
10
20
30
40
50
60
70
0
1
2
3
4
5
6
750
800
850
900
950
FREQUENCY (MHz)

FIG.6

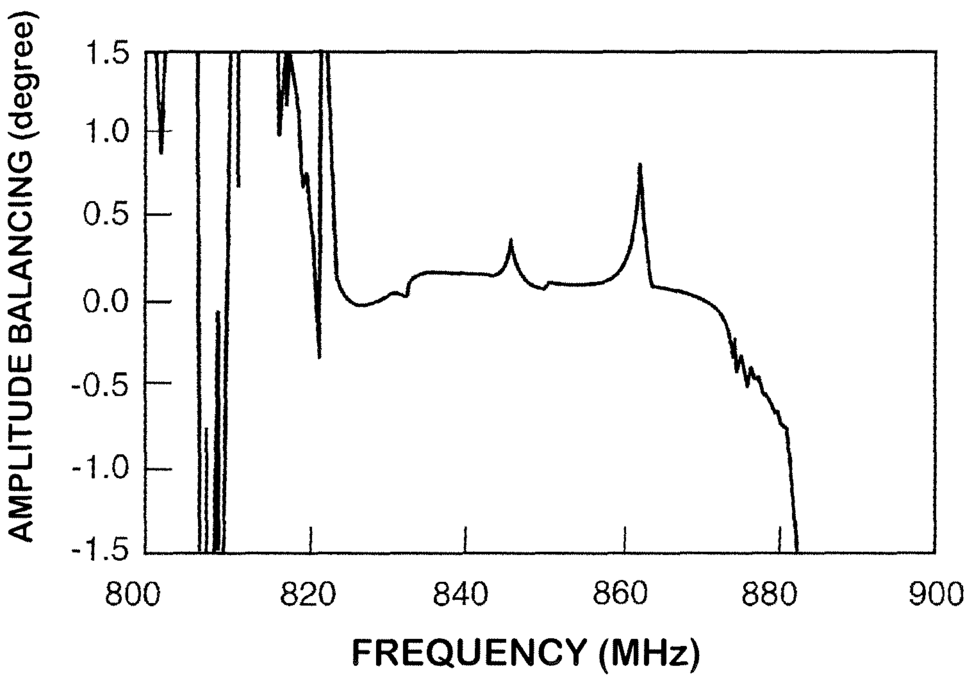
AMPLITUDE BALANCING (degree)
1.5
1.0
0.5
0.0
-0.5
-1.0
-1.5
800
820
840
860
880
900
FREQUENCY (MHz)

FIG.7

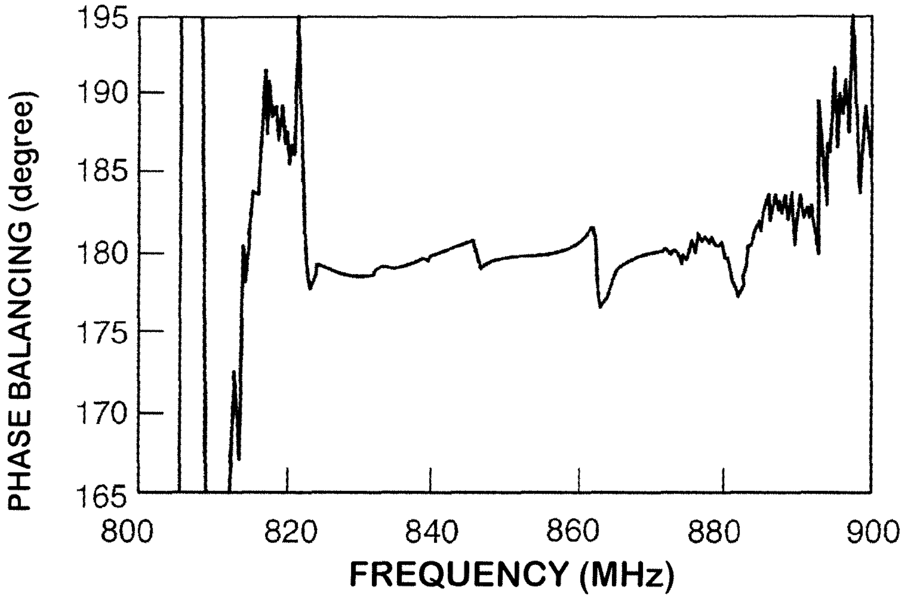
PHASE BALANCING (degree)
195
190
185
180
175
170
165
800
820
840
860
880
900
FREQUENCY (MHz)

FIG.8

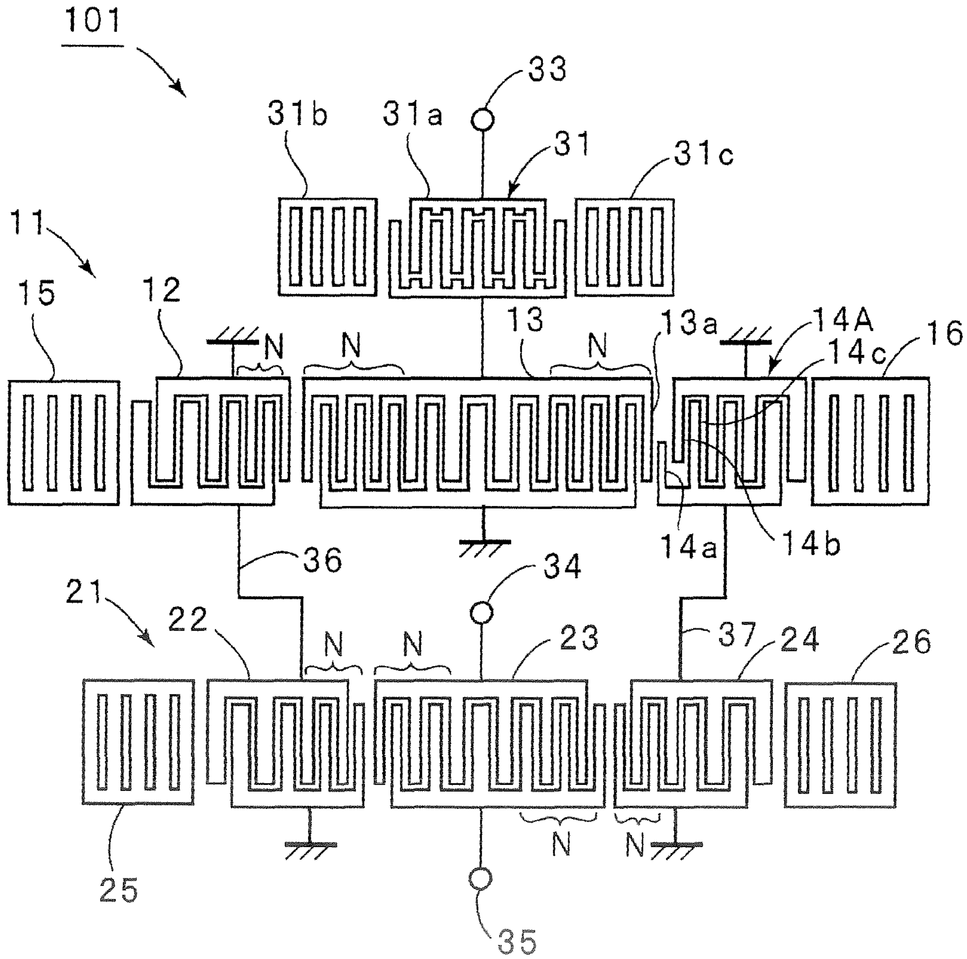
101
33
31b
31a
31
31c
11
15
12
13
13a
14A
14c
16
N
N
N
36
14a
14b
34
21
22
23
37
24
26
N
N
N
N
25
35

FIG.9

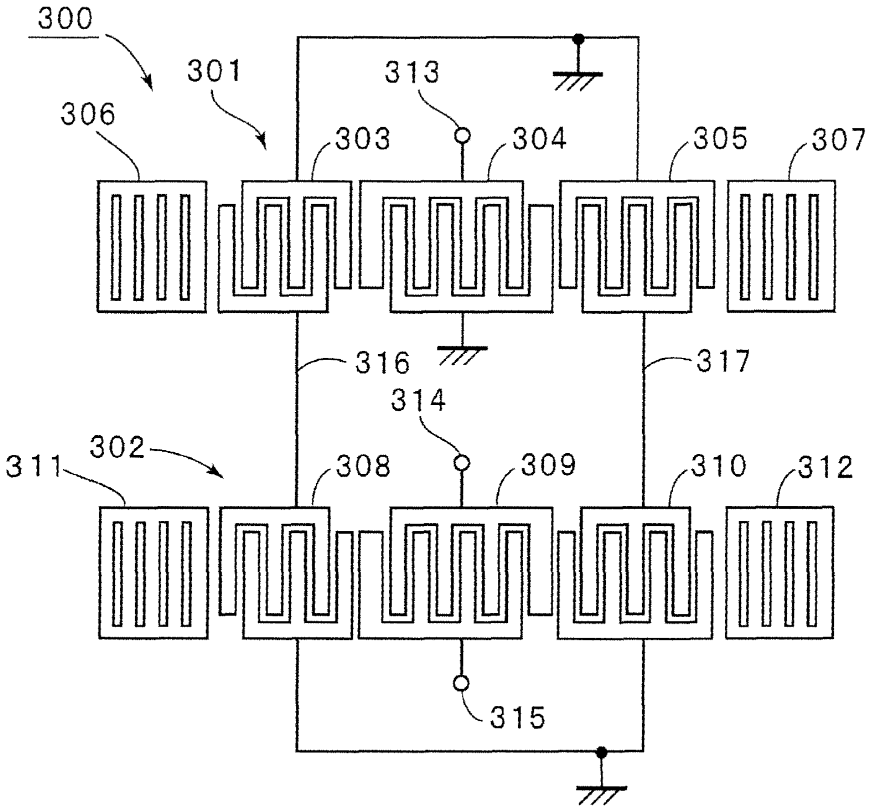
300
301
306
313
303
304
305
307
316
317
314
302
311
308
309
310
312
315

FIG.10

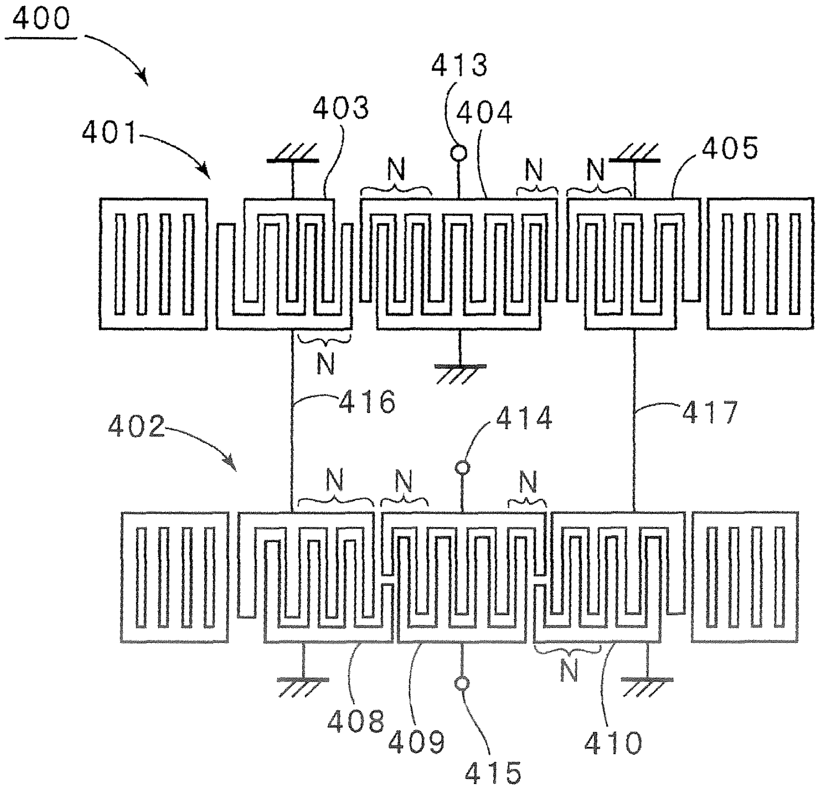
400
401
403
413
404
405
N
N
N
N
416
417
402
414
N
N
N
N
408
409
415
410

**INTERNATIONAL SEARCH REPORT**

International application No.
PCT/JP2005/014551

A. CLASSIFICATION OF SUBJECT MATTER
***H03H9/64*** (2006.01), ***H03H9/145*** (2006.01)

According to International Patent Classification (IPC) or to both national classification and IPC

B. FIELDS SEARCHED

Minimum documentation searched (classification system followed by classification symbols)
***H03H3/08*** (2006.01), ***H03H3/10*** (2006.01), ***H03H9/145*** (2006.01), ***H03H9/25*** (2006.01), ***H03H9/42*** (2006.01), ***H03H9/44*** (2006.01), ***H03H9/64*** (2006.01), ***H03H9/68*** (2006.01), ***H03H9/72*** (2006.01), ***H03H9/76***(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-507917 A (Epcos AG.), 25 February, 2003 (25.02.03), Par. No. [0012]; Fig. 3 & US 006667673 B1 & EP 001205026 A & WO 01/013514 A1 & DE 019938748 A & CN 001370350 A & CA 002381262 A | 1-7 |
| Y | JP 2002-374147 A (Murata Mfg. Co., Ltd.), 26 December, 2002 (26.12.02), Claim 19; Par. Nos. [0080] to [0128], [0132], [0171], [0183]; Figs. 1, 4, 9, 24, 47, 48 & US 2002/0145361 A1 & EP 001249934 A2 & CN 001384605 A & TW 000543288 B | 1-7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 November, 2005 (07.11.05) | 15 November, 2005 (15.11.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2005/014551

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-528987 A (Epcos AG.),<br>03 September, 2002 (03.09.02),<br>Par. Nos. [0015] to [0028]; Figs. 3, 4<br>& US 006420946 B1 & EP 001125364 A<br>& EP 001248365 A2 & WO 00/025423 A1<br>& DE 019849782 A & DE 059901876 D<br>& CN 001325562 A & CA 002343885 A | 5 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002084164 A
- JP 2004007713 A